# EUROPEAN PATENT SPECIFICATION

(11) **EP 2 790 577 B1**
(45) Date of publication and mention of the grant of the patent: **16.06.2021**
(21) Application number: 12857682.4
(22) Date of filing: 13.12.2012
(51) Int. Cl.: G01R 33/28, G01R 33/36, A61B 5/055

(54) **MR ACTIVE TRACKING SYSTEM**
AKTIVES MR-VERFOLGUNGSSYSTEM
SYSTÈME DE POURSUITE ACTIF POUR LA RM

(30) Priority: 15.12.2011 US 201161576180 P
(43) Date of publication of application: 22.10.2014
(73) Proprietor: Imricor Medical Systems, Inc., Burnsville, Minnesota 55337-2559 (US)
(72) Inventor: WEDAN, Steven R., Savage, Minnesota 55378 (US); LLOYD, Thomas W., Eagan, Minnesota 55123 (US); STENZEL, Gregg S., Victoria, Minnesota 55386 (US)
(74) Representative: Bates, Alan Douglas Henry
(86) International application number: PCT/US2012/069513
(87) International publication number: WO 2013/090577

(56) References cited:
- US-A- 5 268 634
- US-A- 5 384 536
- US-A- 6 051 974
- US-A1- 2003 076 105
- US-A1- 2004 019 273
- US-A1- 2005 251 031
- US-A1- 2006 226 841
- US-A1- 2007 167 726
- US-A1- 2010 037 902
- US-A1- 2010 117 649
- US-A1- 2011 046 707
- US-B1- 6 549 009
- US-B1- 7 573 267
- US-B2- 6 856 494
- US-B2- 6 865 494
- JENS ANDERS ET AL: "Integrated active tracking detector for MRI-guided interventions", MAGNETIC RESONANCE IN MEDICINE, vol. 67, no. 1, 29 August 2011 (2011-08-29), pages 290-296, XP055046646, ISSN: 0740-3194, DOI: 10.1002/mrm.23112
- BOTTOMLEY PAUL ET AL: "Designing passive MRI-safe implantable conducting leads with electrodes", MEDICAL PHYSICS, AIP, MELVILLE, NY, US, vol. 37, no. 7, 29 June 2010 (2010-06-29), pages 3828-3843, XP012144856, ISSN: 0094-2405, DOI: 10.1118/1.3439590
- FANDREY S ET AL: "Development of an Active Intravascular MR Device With an Optical Transmission System", IEEE TRANSACTIONS ON MEDICAL IMAGING, IEEE SERVICE CENTER, PISCATAWAY, NJ, US, vol. 27, no. 12, 1 December 2008 (2008-12-01), pages 1723-1727, XP011227080, ISSN: 0278-0062, DOI: 10.1109/TMI.2008.925079
- JENS ANDERS ET AL: "A fully integrated IQ-receiver for NMR microscopy", JOURNAL OF MAGNETIC RESONANCE, vol. 209, no. 1, 19 December 2010 (2010-12-19), pages 1-7, XP028141930, ISSN: 1090-7807, DOI: 10.1016/J.JMR.2010.12.005 [retrieved on 2010-12-19]
- None

## Description

### FIELD OF THE INVENTION

The invention relates to a device for tracking the location of a Coil within the medical device.

### BACKGROUND OF THE INVENTION

MRI has achieved prominence as a diagnostic imaging modality, and increasingly as an interventional imaging modality. The primary benefits of MRI over other imaging modalities, such as X-ray, include superior soft tissue imaging and avoiding patient exposure to ionizing radiation produced by X-rays. MRI's superior soft tissue imaging capabilities have offered great clinical benefit with respect to diagnostic imaging. Similarly, interventional procedures, which have traditionally used X-ray imaging for guidance, stand to benefit greatly from MRI's soft tissue imaging capabilities. In addition, the significant patient exposure to ionizing radiation associated with traditional X-ray guided interventional procedures is eliminated with MRI guidance.

MRI uses three fields to image patient anatomy: a large static magnetic field, a time-varying magnetic gradient field, and a radiofrequency (RF) electromagnetic field. The static magnetic field and time-varying magnetic gradient field work in concert to establish proton alignment with the static magnetic field and also spatially dependent proton spin frequencies (resonant frequencies) within the patient. The RF field, applied at the resonance frequencies, disturbs the initial alignment, such that when the protons relax back to their initial alignment, the RF emitted from the relaxation event may be detected and processed to create an image.

Each of the three fields associated with MRI presents safety risks to patients when a medical device is in close proximity to or in contact either externally or internally with patient tissue. One important safety risk is the heating that can result from an interaction between the RF field of the MRI scanner and the medical device (RF-induced heating), especially medical devices which have elongated conductive structures such as transmission lines in catheters, sheaths, guidewires, stent or valve delivery systems, ICD leads, pacemaker leads, neurostimulator leads, or the like.

A variety of MRI techniques are being developed as alternatives to X- ray imaging for guiding interventional procedures. For example, as a medical device is advanced through the patient's body during an interventional procedure, its progress may be tracked so that the device can be delivered properly to a target site. Once delivered to the target site, the device and patient tissue can be monitored to improve therapy delivery. Thus, tracking the position of medical devices is useful in interventional procedures. Exemplary interventional procedures include, for example, cardiac electrophysiology procedures including diagnostic procedures for diagnosing arrhythmias and ablation procedures such as atrial fibrillation ablation, ventricular tachycardia ablation, atrial flutter ablation, Wolfe Parkinson White Syndrome ablation, AV node ablation, SVT ablations and the like. Tracking the position of medical devices using MRI is also useful in renal denervation ablation procedures and oncological procedures such as breast, liver and prostate tumor ablations; as well as urological procedures such as uterine fibroid and enlarged prostate ablations; and neurological procedures such as cranial nerve stimulation and deep brain stimulation. Thus, as the field of interventional MRI grows and more patients are catheterized in the MR environment, the need for safe devices in the MRI environment increases.

The RF-induced heating safety risk associated with transmission lines in the MRI environment results from a coupling between the RF field and the elongated conductor. In this case several heating related conditions exist.

One condition exists where RF induced currents in the elongated conductor may cause Ohmic heating in the elongated conductor itself and/or the components connected to the elongated conductor, and the resultant heat may transfer to the patient. In such cases, it is important to attempt to both reduce the RF induced current present in the elongated conductor and to limit the current delivered into the connected components. Another condition exists where RF currents in the elongated conductor couple to conductive structures that contact tissue. In this situation, RF currents induced on the elongated conductor may be delivered into the tissue through a conductive structure not in direct electrical contact with the elongated conductor resulting in a high current density in the tissue and associated Joule or Ohmic tissue heating. Also, when the elongated conductor is connected to circuitry that is tissue contacting, direct injection of the induced current into the tissue may occur resulting in a high current density in the tissue and associated Joule or Ohmic tissue heating. Lastly, RF induced currents on the elongated conductor may result in increased local specific absorption of RF energy in nearby tissue, thus increasing the tissue's temperature. The foregoing phenomenon is referred to as dielectric heating. Dielectric heating may occur even where no thermal or electrical contact to the tissue exists.

Many devices used in the MRI environment can benefit from actively tracking the location of one or more "tracking coils" implemented on or in the device. These tracking systems, however, require the use of transmission lines such as coaxial cable, twisted pair, triaxial cable, etc., which, as elongated conductors, introduce the risks outlined above.

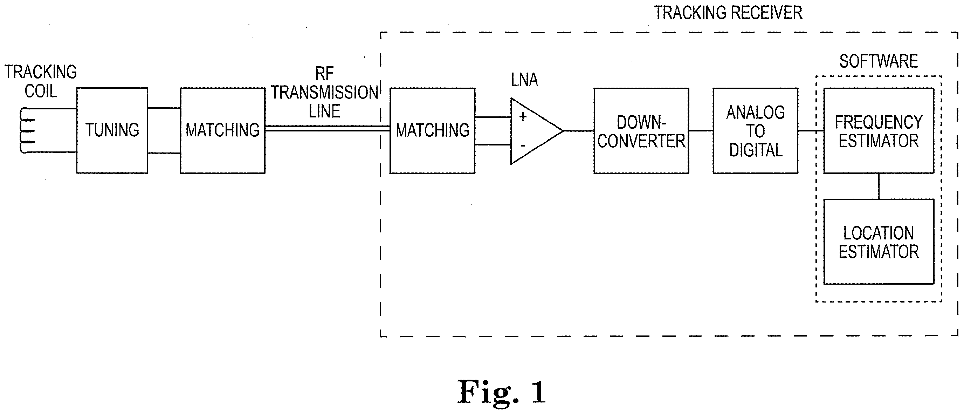

Traditionally to track the location of a device in the MRI environment, a tracking system such as that depicted in FIG. 1 has been used. A tracking coil receives the MR signal via either wire or circuit board traces. Then, a tuning circuit tunes the tracking coil to the MR frequency of interest. A matching network electrically matches the tuned tracking coil to the transmission line. A transmission line carries the MR signal out of the device to a tracking receiver. A tracking receiver receives and processes the MR signal to determine the location of the tracking coil. The tracking receiver typically includes a matching network, a low-noise amplifier, a frequency down-converter, an analog to digital converter and software to determine the location of the tracking coil from the frequency content of the received signal. The tracking receiver is a generic term used to depict any subsystem that connects to the tracking coil (through various circuits). Those of skill in the art will appreciate; however, that it is typically not a part of the device being tracked.

JENS ANDERS ET AL: "Integrated Active Tracking Detector for MRI-Guided Interventions", Magnetic Resonance in Medicine, Vol 67, No. 1, 29 August 2011, pages 290-296, relates to a fully integrated detector for active tracking of interventional devices in MR-guided interventions.

Recently, tracking systems have been developed which move some of the above-mentioned components from the tracking receiver to the tracking coil location. This modification eliminates some components, including the matching networks and transmission line, which may result in a decrease in the loss associated with the transmission line, a decrease in the noise in the signal, and a potential increase in the signal to noise ratio for the entire tracking system. For the purposes of this disclosure, we refer to such systems as "IC at Coil" tracking systems, because these systems include placing an integrated circuit near the tracking coil.

However, even with IC at Coil tracking systems, the issue of heating and compromising patient safety is still present. The wires used to communicate the received and down-converted signal to the tracking receiver may still allow for RF heating issues previously discussed. In addition, present attempts to implement IC at Coil tracking systems require wires connected from the tracking receiver to the IC at Coil. Such wires provide power, ground and a frequency reference signal (used in the down-conversion process). All of these conductors create the RF heating risk in the MR environment.

In addition, if the frequency determination (typically meaning estimating a mean frequency from the received MR signal) could be done at the tracking coil location, then the amount of information needed to be communicated from the tracking coil location to the tracking receiver could be minimized, decreasing the potential for signal interference with the MR system. This would also have the advantage of decreasing the complexity of the tracking receiver.

Thus, a tracking system that significantly minimizes RF heating that may compromise patient safety and in addition decreases the complexity of the tracking receiver is needed.

### BRIEF SUMMARY OF THE INVENTION

The present invention addresses the foregoing need with an IC at Coil tracking system in which the transmission line is eliminated. We define transmission line to mean one that is formed by conductive surfaces, such as coaxial cables, striplines, triaxial cables, twisted pair, etc. Therefore, a "transmission line" as defined does not include fiber optic cables or other cables that do not electrically conduct.

The novel configuration of a tracking system that overcomes the heating problems of conventional transmission line and signal line conductors is describe herein. By integrating certain components at the tracking coil location of the device, the high frequency transmission line which poses a heating risk can be replaced by MR safe conductors or fiber optics. In addition, the present invention is a novel configuration that performs additional signal processing (frequency estimation, analog to digital conversion, etc.) at the tracking coil location to reduce the amount of processing required in the tracking receiver and decrease the potential for signals passing from tracking coil location to the tracking receiver from interfering with MR imaging signals.

The tracking system in accordance with the invention describes multiple means of communicating the received and down-converted MR signal to the tracking receiver safely in the MR.

The invention comprises multiple means of powering such a device safely in the MR.

The invention further comprises multiple means of providing or creating the needed reference frequency for down-conversion.

The invention further comprises multiple means of performing the main frequency estimation at the tracking coil location.

Examples that do not form part of the claimed invention further comprise multiple means of eliminating the down-conversion by doing an analog to digital conversion or direct frequency estimation at the tracking coil location.

The invention further comprises multiple tracking coils wherein each tracking coil is coupled to a corresponding IC and communication line.

The invention further comprises multiple tracking coils each of which is coupled to a single IC with a single communication line.

The invention further comprises multiple tracking coils each of which is coupled to a single IC with a single communication line wherein the IC incorporates a method such as multiplexing, to transmit the multiple communication signals on a single line.

The MR active tracking system according to the invention comprises an integrated circuit active tracking coil (IC at coil), comprising an active tracking coil, an integrated circuit proximate the active tracking coil, a frequency down-converter configured to down-convert a magnetic resonance (MR) signal received by the active tracking coil, and a frequency generator; a tracking receiver; a first MR safe means configured for transmitting a received and downconverted MR signal from the IC at coil to the tracking receiver; and a second MR safe means configured for communicating one or more signals from the tracking receiver to the IC at coil, wherein said active tracking coil is configured to sample an MR transmit excitation pulse, or alternatively wherein the IC at coil comprises a separate sense coil configured to sample an MR transmit excitation pulse, and wherein the frequency generator is configured to generate a reference frequency signal from the sampled MR transmit excitation pulse, and wherein the frequency down-converter is configured for down-conversion of an MR signal received by the active tracking coil using the reference frequency signal. The integrated circuit may also include frequency estimations, analog to digital conversion at the tracking coil location to reduce the amount of processing required in the tracking receiver thereby decreasing the potential for signals passing from the tracking coil location to the tracking receiver to interfere with MR imaging signals.

### BRIEF DESCRIPTION OF THE DRAWINGS

FIG. 1 depicts a conventional tracking coil and tracking receiver coupled by an RF transmission line.
FIG. 2 illustrates an example of an MR active tracking system that does not form part of the claimed invention.
FIG. 3 illustrates another example of an MR active tracking system that does not form part of the claimed invention in which a frequency estimator circuit is placed on the IC at Coil.
FIG. 4 illustrates another example of an MR active tracking system that does not form part of the claimed invention in which an analog to digital converter is placed on the IC at Coil.
FIG. 5A and 5B illustrate alternative aspects of an MR active tracking system in which a reference frequency signal is generated at the IC at coil, wherein FIG. 5A depicts an example that does not form part of the claimed invention, and FIG. 5B depicts an embodiment according to the present invention.
FIG. 6A and 6B illustrate examples of an MR active tracking system that do not form part of the claimed invention in which power is supplied to the IC at Coil.
FIG. 7 illustrates another aspect of an MR active tracking system in which a wireless module may be included in the tracked device.
FIG. 8 is a diagram depicting an MR compatible inductive cable in which non-resonant filters are distributed along a wire in a spaced apart relationship with an optional resonant LC filter proximate an IC at Coil.
FIG. 9 is a sectional view of an exemplary MR compatible conductive cable forming non-resonant filters distributed along the length of wires and each wire forming an optional resonant LC filter proximate an IC at Coil.
FIG. 10 shows a detailed view of the non-resonant filters and optional resonant LC filters of FIG. 9A.
FIG. 12 depicts an inductive cable in which multiple non-resonant inductors formed from a single wire are grouped together and distributed along the wire and further forming an optional resonant LC filter proximate an IC at Coil.

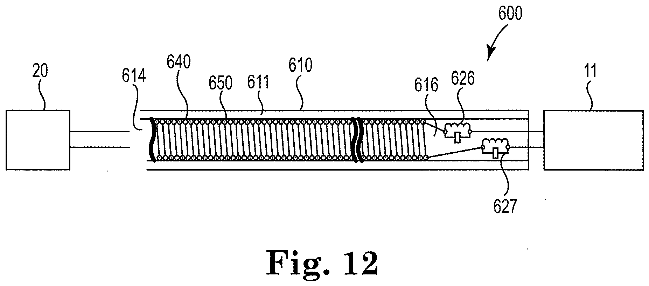

FIG. 12 is a schematic view of co-radially wound wires positioned inside an exemplary inductive cable with optional resonant LC filters proximate an IC at Coil.

### DETAILED DESCRIPTION OF THE INVENTION

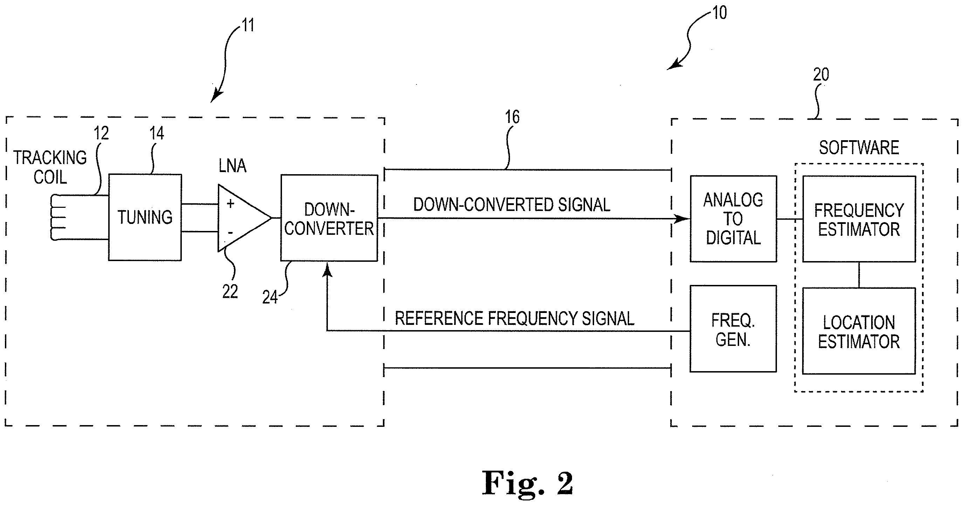

Referring to FIG. 2, the exemplary MR active tracking system 1 which does not form part of the claimed invention comprises an IC at Coil circuit including an active tracking coil 12; an integrated circuit 14 located proximate the active tracking coil; a means 16 for safely communicating a received and down-converted MR signal to a tracking receiver 20; and a means for communicating a reference frequency, power, and ground from the tracking receiver to the IC.

In one aspect of the invention, the tracking coil 12 may comprise traces on a circuit board, coiled wire, and/or a dipole. The integrated circuit 14 located adjacent to the active tracking coil may comprise a low noise amplifier 22; a frequency down-converter 24; a signal transmission stage; and/or support hardware. The means for communicating between the tracking receiver and the IC at coil comprises a cable construct 16 including a wire forming at least one non-resonant filter as hereinafter described, a high resistance wire or wires, a fiber optic cable and/or any combination of the foregoing depending on the number of signals that are being transmitted. For example, in the example that does not form part of the claimed invention depicted in FIG. 2 two wires are received with cable 16. The wire or conductive path forming at least one non-resonant filter may optionally include at least one resonant LC filter. The resonant LC filter is most always placed proximate the IC at Coil; however, the resonant LC filter may be placed proximate the tracking receiver. Further, the resonant LC filter may comprise a plurality of resonant LC filters placed proximate the IC at coil, the tracking receiver or both.

The wires for communicating the received and down-converted MR signal to the tracking receiver may comprise a high resistance wire or wires or a fiber optic cable or cables. If the means for communicating comprises a fiber optic cable or cables then the IC at Coil 11 may include a fiber optic drive circuit and any required support hardware (e.g. a modulator). Additionally, if a fiber optic cable is used, a light-to-power transducer circuit is used in the IC at Coil. The means for communicating a reference frequency from the tracking receiver 20 to the IC at Coil 11 may also comprise the elements discussed above in reference to the means for safely communicating the received and down-converted MR signal to the tracking receiver.

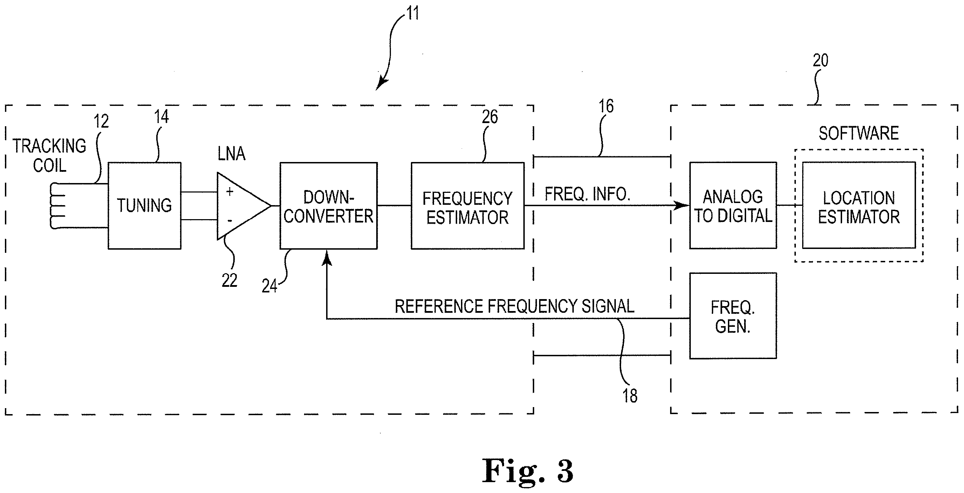

Referring now to FIG. 3, which depicts another example of an MR active tracking system that does not form part of the claimed invention, another aspect of the invention includes placing a frequency estimator circuit 26 on the IC at Coil 11 such that frequency information is passed from the IC at Coil 11 to the tracking receiver 20 through MR safe means 16 including by way of example and not of limitation high resistance wires; fiber optic cables (including a fiber optic drive circuit and any required support hardware); or a wire forming at least one non-resonant filter. Optionally the wire or conductive path forming at least one non-resonant filter may include at least one resonant LC filter as hereinafter described.

Referring again to FIG. 3, which depicts an example not forming part of the claimed invention, a frequency down-converter 24 on the IC at Coil is shown but may optionally be included. If a frequency down-converter 24 is optionally eliminated then the means for transmitting a reference frequency signal 18 may also be eliminated. The frequency information signal may be a voltage, a light code, a pulse signal whose rate represents a frequency, etc. One way to estimate the frequency may be to implement a zero-crossing circuit that sends a pulse of light to the tracking receiver 20 at each zero crossing through a fiber optic cable. By measuring the time between pulses, a frequency estimation may be made. Those of skill in the art will appreciate that the analog to digital converter may optionally be eliminated also depending on the frequency information signal. For example, zero crossing circuit above may not require the analog to digital converter.

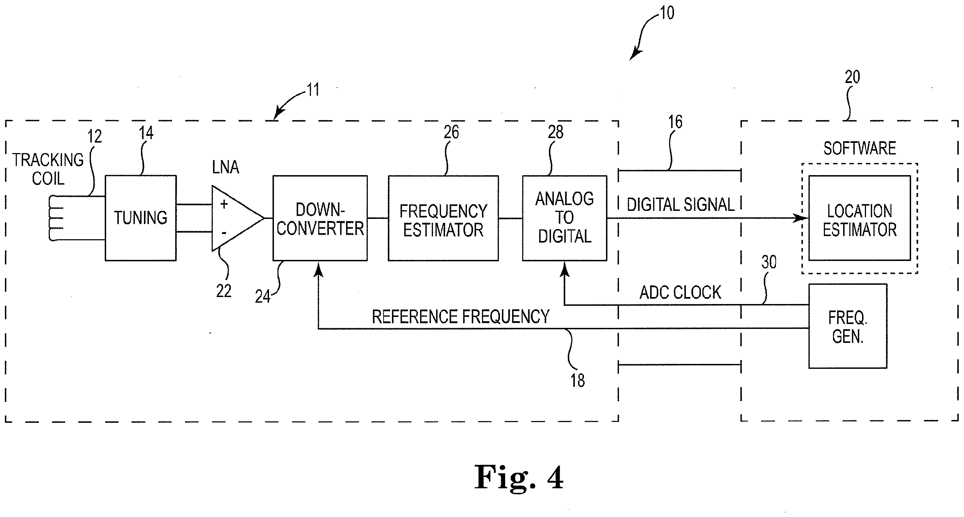

A further aspect of an active tracking system 10 includes placing an analog to digital converter (ADC) 28 on the IC at Coil 11, such that a digital signal is communicated from the IC at Coil 11 to the tracking receiver 20 through MR safe means 16. This is shown in Figure 4, which depicts an example of an MR active tracking system that does not form part of the claimed invention. MR safe means may include high resistance wires; a fiber optic cable or cables (including a fiber optic drive circuit and any required support hardware); a wire forming at least one non-resonant filter or any combination of the foregoing. Those of skill in the art will appreciate that any conductive path containing or forming at least one non-resonant filter is contemplated to be within the scope of the invention. Optionally the wire or conductive path forming at least one non-resonant filter may include at least one resonant LC filter as hereinafter described.

Referring again to FIG. 4, an ADC clock signal 30 for the analog to digital converter 28 may be communicated from the tracking receiver 20 to the IC at Coil through MR safe means 16 including high resistance wires; a fiber optic cable or cables (including a fiber optic drive circuit and any required support hardware); a wire forming at least one non-resonant filter 16 and/or combinations of the foregoing. As noted above, those of skill in the art will appreciate that any conductive path containing or forming at least one non-resonant filter is contemplated to be within the scope of the invention. Optionally the wire or conductive path forming at least one non-resonant filter may include at least one resonant LC filter as hereinafter described. Therefore, in one exemplary embodiment, the power line supplying the IC at coil is inductive.

The example depicted in FIG. 4, which does not form part of the claimed invention, may optionally include a frequency down-converter 24 or frequency estimator 26. If the frequency down-converter 24 is eliminated, a reference frequency signal may not be needed and line 18 may also be eliminated. If a reference frequency signal is needed, the line 18 may also be used to generate the ADC clock signal 30. In addition, frequency estimator 26 at IC tip is also optional and this function may be located in the tracking receiving 20 as depicted in FIG. 2.

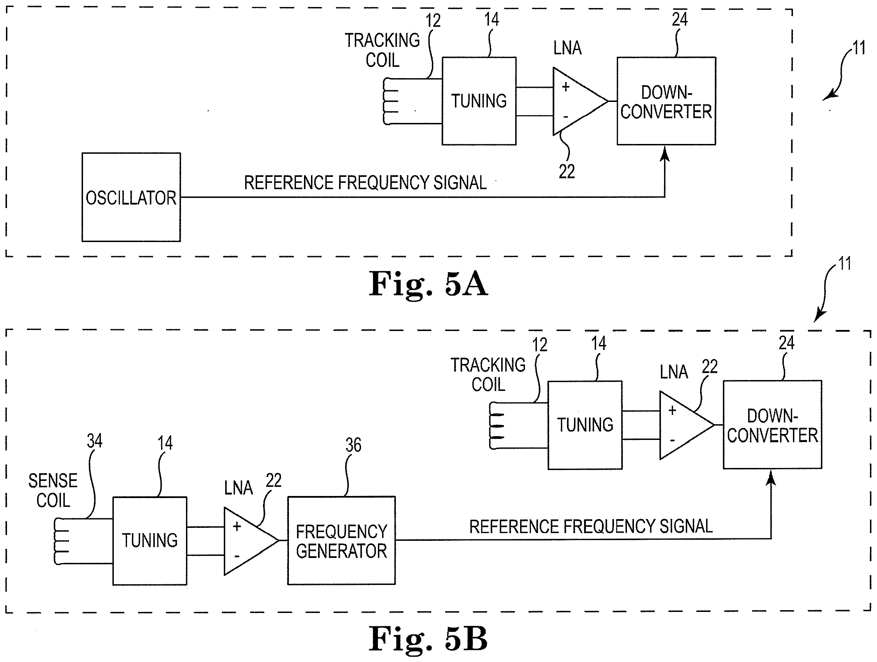

Referring now to FIGS. 5A and 5B, another example that does not form part of the claimed invention is shown in FIG. 5A, and another aspect of the invention 10 is shown in FIG. 5B. The IC at Coil may include any of the elements illustrated in FIGS. 2 - 4, such as frequency estimator, etc., except that the reference frequency signal is generated in the IC at Coil. This eliminates the need for conductors that deliver the reference frequency signal from the tracking receiver 20. This may be accomplished in several ways, such as including an oscillator 32 and support circuitry on the IC at Coil as shown in the example that does not form part of the claimed invention in FIG. 5A; or, as in the embodiment depicted in FIG. 5B, using a sense coil 34 and support circuitry on the IC at Coil to sample the MR transmit excitation pulse and generate a reference frequency signal from the MR transmit excitation pulse. The frequency generator 36 will use the received MR excitation pulse carrier to generate a frequency reference signal. If a sense coil is used, the sense coil 34 may also comprise a tracking coil. Alternatively, the sense coil 34 may be positioned adjacent the tracking coil (not shown). Still alternatively, the IC at Coil may include both a tracking coil and a sense coil as best seen in FIG. 5B. Those of skill in the art will appreciate that the invention may comprise multiple tracking coils wherein each tracking coil is coupled to a corresponding IC and communication line or may comprise multiple tracking coils each of which is coupled to a single IC with a single communication line both of which are within the intended scope of the invention. Those of skill in the art will also appreciate that the invention may further comprise multiple tracking coils each of which is coupled to a single IC with a single communication line wherein the IC incorporates a method such as multiplexing, to transmit the multiple communication signals on a single line without departing from the scope of the invention. Therefore, the IC at Coil may comprise one or two coils. If one coil is used the coil is both a tracking coil and a sense coil on one circuit. Alternatively, the circuit may be split to form two circuits. If two coils are used, a sense coil and a tracking coil, each coil may have its own dedicated circuit. The output of the sense coil 34 may optionally be amplified by low noise amplifier 22 as shown in FIG. 5B or by its own internal low noise amplifier for the purpose of generating a reference frequency signal. However, those of skill in the art will appreciate that a low noise amplifier 22 may optionally be eliminated if the MR excitation pulse has a high magnitude.

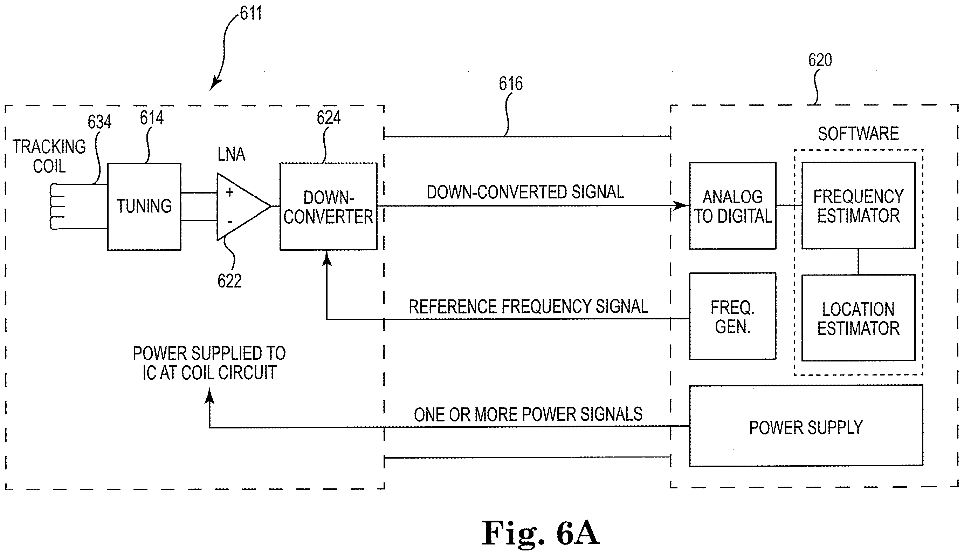

As those of skill in the art will appreciate, the systems illustrated in FIGS. 2 - 5 require power. Referring now to FIG. 6A, which depicts an exemplary MR active tracking system that does not form part of the claimed invention, if the power is supplied by the tracking receiver 20, then the power is routed to the IC at Coil through MR safe connections such as those described above, e.g. high resistance wires, fiber optic cables, or wires that form at least one non-resonant filter. If a fiber optic cable is used, a light-to-power transducer circuit is used in the IC at Coil. Those of skill in the art will again appreciate that any conductive path containing or forming at least one non-resonant filter is contemplated to be within the scope of the invention. Optionally the wire or conductive path forming at least one non-resonant filter may include at least one resonant LC filter.

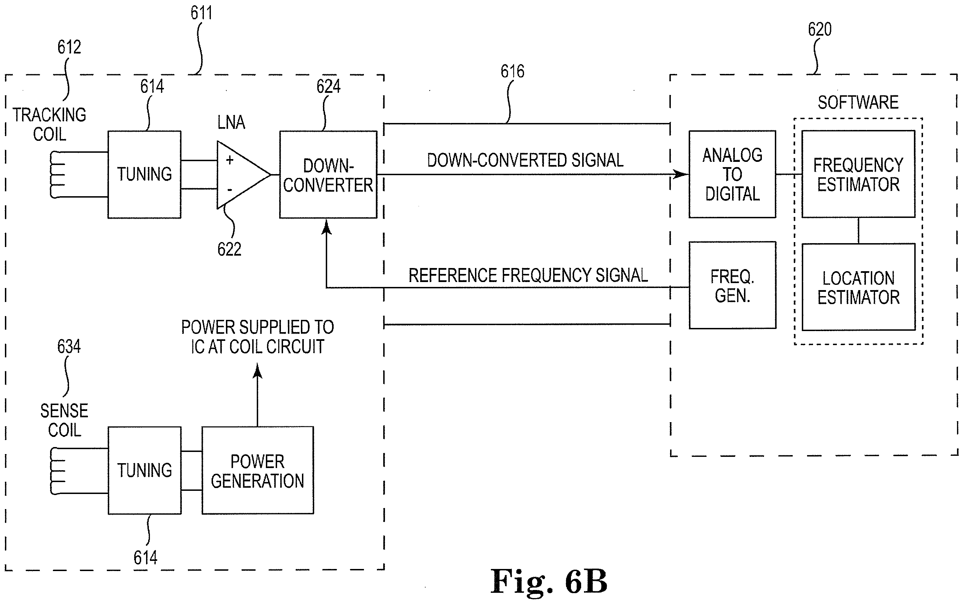

Referring to FIG. 6B, another example of an active tracking system that does not form part of the claimed invention is shown. The power for the IC at Coil circuit is sourced by the IC at Coil. The active tracking system 600 generates power on the IC at Coil 611 by harvesting power from the MR transmit excitation pulses, similar to RFID applications, using a sense coil 634 and power generation circuitry (conventional AC to DC conversion techniques known to those of skill in the art). In such a system, the sense coil 634 may or may not be the tracking coil. The sense coil 634 picks up the 64 MHz for a 1.5 Tesla MRI or approximately 128 MHz for a 3.0 Tesla MRI radio frequency signal, which is passed through tuning circuit 614 creating power generation which is supplied to the IC at Coil circuit. As seen in FIG. 6B, the down-converted signal and reference frequency signal are passed through cable 616 which may include, as in other embodiments or examples that do not form part of the claimed invention, high resistance wires, fiber optic cables, wires forming non-resonant filters and optional resonant LC filters and combinations of the foregoing. If a fiber optic cable is used, a light-to-power transducer circuit is used in the IC at Coil. When MR safe wires are used in cable construct 616 DC voltage is passed with minimal loss.

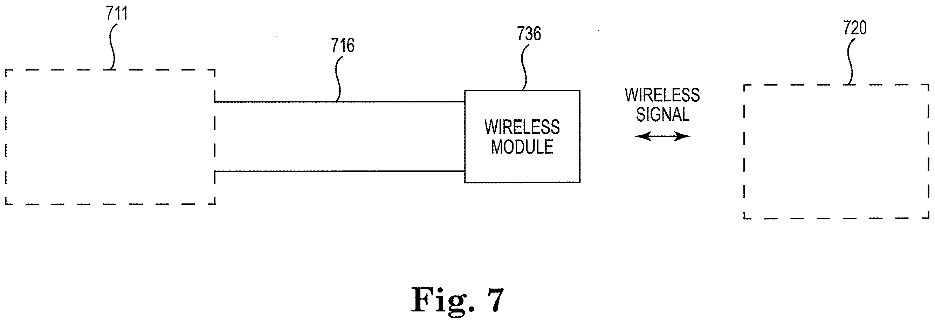

Referring now to FIG. 7 a further aspect of the invention is illustrated. The invention of FIG. 7 may include any of the aspects of the invention illustrated in FIGS. 2 - 6 except that a wireless module 736 may be included in the tracked device at the proximal end thereof for wireless communication with the tracking receiver 720, which also includes wireless. The wireless module 736 may be a radio or a polled device. The tracked device may establish a continuous wireless channel with the tracking receiver 720 or it could be polled by the tracking receiver. If it is polled, then it may or may not be powered by the poling device, similar to RFID applications.

The foregoing embodiments may also include multiple tracking coils where each coil has a corresponding IC and communication line(s); or multiple tracking coils each of which is coupled to a single IC with a single communication line. Those of skill in the art will appreciate that multiple tracking coils each of which is coupled to a single IC at Coil with a single communication line may incorporate a mechanism or method to transmit the multiple communication signals on a single line such as multiplexing and like methods known to those of skill in the art.

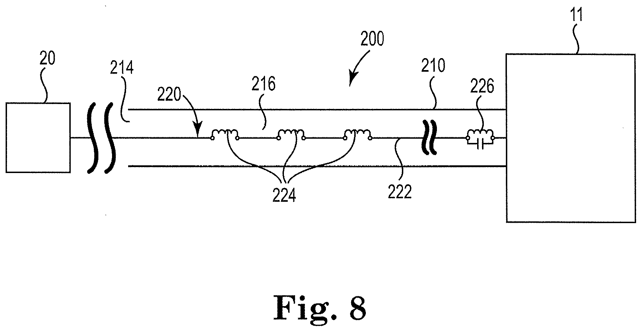

Referring now to FIGS. 8 - 12 an exemplary inductive cable used in or as cable construct 16, 616, 716 will now be described. For purposes of simplicity only we refer only to numeral 16 as the cable construct in the disclosure below. However, those of skill in the art will appreciate that cable constructs such as those depicted at 616 and 716 are within the scope of the invention.

FIG. 8 is a schematic diagram depicting an aspect of the inductive cable of the invention. Inductive cable 200 broadly includes an elongate body 210 having first 212 and second 214 ends and includes lumen 216 therewithin. Inductive cable 200 is operably connected at a first end to the IC at Coil 11 and at the second end to the tracking receiver 20 or alternatively tracking receiver 620, 720. Those of skill in the art will appreciate that IC at Coil 11 as depicted in FIGS. 8-12, may include any of the IC at Coil implementations depicted in FIGS. 2-6, the invention being defined by the claims. Lumen 216 houses circuit 220. Circuit 220 includes at least one conductive wire 222 forming a plurality of spaced apart filter components 224. Each circuit may constructed from a single, continuous length of non-magnetic wire such as copper, titanium, titanium alloys, tungsten, gold, MP35N and combinations of the foregoing. Alternatively, each circuit may comprise multiple lengths of wires. As with the conventional MR active tracking system depicted in FIG. 1, which does not form part of the claimed invention, wire 222 is a bondable wire such as heat, chemical or adhesively bondable to permit formation of the filters during manufacture with one wire. This eliminates the necessity for connection points at each end of each filter 224 and thereby improving the mechanical durability of the circuit 220 and reducing the manufacturing cost thereof. In the illustrated embodiment, the wire assembly 200 includes optional resonant LC filter 226 positioned adjacent and proximal to the IC at Coil interface 228. Resonant LC filter 226, 326, 327526 626, and 627 as depicted in FIGS. 8-12 are optional. Optional resonant LC filter wire assembly 226 is adapted to effectively block RF induced current from exiting the wire 200 and passing into the IC at Coil. Optional resonant LC filter 226 effectively blocks RF induced current by being constructed such that the inductive and capacitive characteristics of the filter together resonate to create a high impedance at the MRI RF frequency of interest for example, approximately 64 MHz for a 1.5 Tesla MRI or approximately 128 MHz for a 3.0 Tesla MRI. Filtering components 224 distributed along the length of the wire attenuate the induced current on the wire itself before the current reaches resonant LC filter 226 thereby avoiding excessive heating of resonant LC filter 226. The filtering components 224 together preferentially create at least 1,000 or more Ohms of impedance along the entire circuit 220, for a lead length of approximately 1 meter. Those of skill in the art will appreciate that the amount of total impedance will necessarily change as the lead length varies. Each filtering component 224 may comprise an inductor formed by wire 222 with approximately 45 turns, creating approximately 150 Ohms, when sized to fit in an 8 French catheter assuming an inside diameter of the inductor to be 0.045 inches. Fewer turns are necessary to create the same impedance for larger diameter inductors. Filtering components 224 may be spaced non-uniformly, such that the segments of wire between them each have a different resonant frequency, or substantially uniformly.

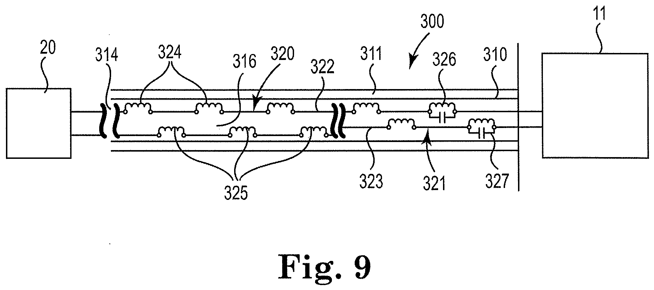

Referring now to FIG. 9 a detailed sectional view of one embodiment of the invention is illustrated. Wire assembly 300 includes elongate body 310 surrounded by jacket 311. Elongate body 310 includes first 312 and second 314 ends and includes lumen 316 therewithin. Second end 314 is adapted to be connected to electronic controls, internal or external to the patient body, and may include a connector (not shown). Lumen 316 houses circuits 320, 321. Circuits 320, 321 each include one conductive wire 322, 323, respectively, located within the lumen 316 of wire assembly 300. Each conductive wire 322, 323 comprises a single length of conductive wire, each of which forms a plurality of spaced apart filter components 324, 325, respectively. Filter components 324, 325 comprise non-resonant filters or inductors that are spaced apart along the length of conductive wires 322, 323.

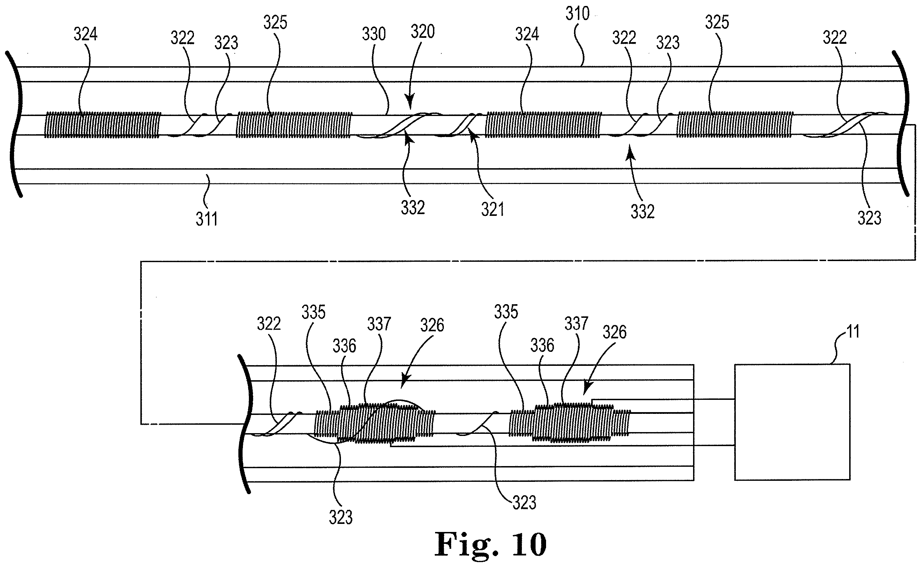

The first and second conductive wires 322, 323 are electrically insulated from one another. Both the first and second conductive wires 322, 323 may include an insulative or non-conductive coating. Preferably the insulative coating is a heat bondable material such as polyurethane, nylon, polyester, polyester-amide, polyester-imide, polyester-amide-imide and combinations of the foregoing. Alternatively, only one wire may be insulated. The wire insulation comprises the bondable material mentioned previously. In addition, circuits 320, 321, as best seen in FIG. 10, are further electrically insulated as both wires 322, 323 are wound around non-conductive tube 330 defining a lumen therewithin. Tube 330 may be formed of a silicone material, Teflon, expanded tetrafluoroethylene (eTFE), polytetrafluoroethylene (pTFE), or the like, as described below. Winding the non-resonant filters 324, 325 or inductors around non-conductive tube 330 facilitates construction of the inductors and resonant LC circuit. Moreover, non-conductive tube 330 advantageously allows the circuits to maintain flexibility and maneuverability when placed inside an elongate body. Advantageously, other items necessary or desirably used in the surgical or interventional procedure such as fiber optic cables, irrigation lumens, coaxial cables may also be passed through the lumen of tube 330.

Referring to FIG. 9 lumen 316 houses circuits 320, 321 comprising wires 322, 323, respectively. As discussed previously, each wire 322, 323 forms a plurality of spaced apart filter components 324, 325 comprising non-resonant filters. As in previous embodiments, each circuit is optionally constructed from a single, continuous length of non-magnetic wire such as copper, titanium, titanium alloys, tungsten, gold, MP35N and combinations of the foregoing; however, each circuit may alternatively be constructed from multiple lengths of wires or include discrete filter components connected by separate lengths of wires. If all filters are formed from one length of wire, it is important that the wire is a bondable wire such as heat, chemical or adhesively bondable to permit formation of the filters during manufacture with one wire as will be described below.

Referring now to FIG. 10 each circuit 320, 321 is constructed substantially similarly. Wires 322, 323 are wound over flexible tube 330 which is preferably made from polyimide, polyolefin, pTFE, eTFE, polyetherketone (PEEK) and other similar flexible materials. During manufacture a stiff rod (not shown) is placed inside of flexible tube 330 to provide added support for the wire assembly process. After manufacture, the rod is removed and the flexible tubing 330 with circuit constructs is placed in elongate body 310.

Each circuit 320, 321 is constructed separately with the first circuit 320 being constructed from the distal end to the proximal end starting with the most proximal resonant LC filter 326. Thus, assuming a plurality of circuits, the wire associated with the next most distal resonant LC filter 327 passes over the resonant LC filter that is most proximal. Passing an wire below a resonant LC filter will adversely affect its resonance. On the other hand, passing a wire underneath a non-resonant inductor will not adversely affect its performance. Thus, exemplary resonant LC filter 326 is constructed by layering of the wire 322 to form three layers 335, 336, 337. The ratio of turns from inner layer to outer layer may be approximately 3:2:1 resulting in a constant physical geometry of the resonant LC filter. Creating a resonant LC filter is apparent to those skilled in the art, and many embodiments would satisfy the requirements of this invention. For example, a capacitor may be placed in parallel with an inductor. Other types of resonant LC filters would also fall within the scope of the invention.

In an exemplary embodiment, multiple layers of coiled wire are constructed such that the capacitance between the layers and individual turns provide the ratio of inductance to capacitance required to satisfy the resonant condition and provide the maximum impedance at the resonant frequency. As described previously, three layers may be used, the ratio of turns from inner layer to outer layer being approximately 3:2:1. This ratio results in high structural integrity, manufacturability, and repeatability. In the exemplary embodiment, wherein the resonant frequency of the resonant LC filter is approximately 64 MHz to block the RF from a 1.5 Tesla MRI, the inner layer may include 30 turns, the middle layer may include 20 turns, and the outer layer may include 10 turns. In general, the exact number of turns is determined by the space available and the desired resonant frequency. The impedance, bandwidth and quality factor of the resonant LC filter can be adjusted by modifying the ratio of the capacitance to the inductance of the filter. This may be accomplished by changing the number of turns, the number of layers, the ratio of turns between layers, or all of these. For example, the ratio may vary in each case by one, two or three turns to obtain the desired characteristics of the filter.

If an optional resonant LC filter is included in the inductive cable, after forming the most proximal resonant LC filter 326, first wire 322 is helically wound around tube 330. Those of skill in the art will appreciate that connecting segments 332 do not necessarily need to comprise a specific numbers of turns around tube 330. Rather, it is important to wind the wires in such a manner as to include some slack or "play" thereby allowing the wire assembly to maintain its flexibility during use. Inductors 324 are next formed by coiling wire 322 over flexible tube 330. Each inductor 324 may be formed by helically winding or coiling wire 322 approximately forty-five turns, creating approximately 150 ohms, when sized to fit in an 8 French catheter assuming an inside diameter of the inductor to be 0.045 inches. Those of skill in the art will appreciate, however, that fewer turns may be necessary to create the same impedance for larger diameter inductors. Inductors 324 may be spaced non-uniformly, such that the segments of wire between them each have a different resonant frequency, or may be placed substantially uniformly.

Second circuit 321 is constructed next and substantially similarly to circuit 320. Those of skill in the art will appreciate that the exemplary wire assembly illustrated in FIGS. 9 and 10 comprises two circuits 320, 321. However, any number of circuits may be constructed. For example, in one exemplary construct four circuits each comprising a plurality of non-resonant filters and an optional resonant LC filter are electrically coupled to the IC at Coil. In another exemplary construct ten circuits each comprising a plurality of non-resonant filters and an optional resonant LC filter are electrically coupled to the IC at Coil. Any number of circuits can be constructed. In each case, however, the circuit that includes the most proximal resonant LC filter is constructed first and the circuit that includes the most distal resonant LC filter is constructed last so that the plurality of resulting wires housed within a catheter have the connecting wire segments passing over all proximal resonant LC filters. For example, constructing circuits 320, 321 may be done by starting at the proximal end first (rather than the distal end) so long as the circuit that includes the most proximal resonant LC filter is constructed first. In this way the connecting wire segments of the subsequently constructed circuits will always pass over all adjacent, proximal resonant LC filters so that resonance is not disturbed. Other wire assembly techniques will be apparent to those of skill in the art.

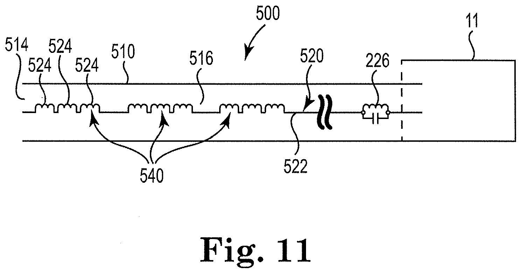

Referring now to FIG. 11 one embodiment of a cable used to connect the tracking receiver to the IC at Coil is shown. In this exemplary circuit 520, multiple, small non-resonant filters 524 are grouped together to form a plurality of inductors 540 positioned in a spaced apart relationship along the length of conductive wire 522. This grouping of filters collectively increases the impedance of each non-resonant filter and reduces the current along the conductive wire 522. As in other embodiments filter component at the IC at Coil interface 528 includes resonant LC filter 526 that is adapted to effectively block RF induced current from exiting the wire assembly 500 into the IC at Coil. Groups 540 of non-resonant filters 524 distributed along the length of wire 522 attenuate the induced current on the wire itself before the current reaches resonant LC filter 526 thereby avoiding excessive heating of resonant LC filter 526. Groups 540 of non-resonant filters 524 may also attenuate the RF current reflected from resonant LC filter 526 thereby attenuating the strong reflected power from the resonant LC filter 526.

Those of skill in the art will appreciate that the inventive inductive cable used to connect the IC at Coil to the tracking receiver may comprise only a plurality of non-resonant filters grouped as shown in FIG. 11 or along the wire construct as shown in FIG. 8.

Referring now to FIG. 12 an alternative inductive cable 600 is shown. As can be seen in FIG. 12 two wires 640, 650 are provided and wound in a co-radial fashion. The co-radially wound wires 640, 650 share a common magnetic flux channel in the center of the windings, such that common mode RF present on both wires will tend to cancel and thus be attenuated. This co-radial approach may be expanded to more than two wires and may comprise any number of co-radially wound wires. Those of skill in the art will appreciate that co-radially wound wires behave as non-resonant filters.

The wire assembly 600 includes elongate body 610 surrounded by optional jacket 611. Elongate body 610 includes first 612 and second 614 ends and includes lumen 616 therewithin. Second end 614 is adapted to be connected to electronics, internal or external to the patient body, and may include a connector (not shown). Lumen 616 houses co-radially wound conductive wires 640, 650. In an alternative embodiment, co-radially wound wires 640, 650 may be embedded in jacket 611. Each co-radially wound wire 640, 650 comprises a single length of conductive wire thereby eliminating the need for bonding points and reducing the possibility of mechanical failure of the wire. The conductive wires 640, 650 are wound in the same direction and the coils have the same diameter. When the wire assembly is exposed to an RF field, as during an MRI scan, the co-radially wound wires 640, 650 tend to block higher frequency common mode RF current from being transmitted along the length of an individual conductive wire. Each co-radially wound conductive wire 640, 650 may have an equal or unequal number of turns. Preferably, however, the conductive wires 640, 650 include an equal number of turns to minimize the amount of RF leakage from the coil, such leakage resulting in less effective RF current blocking. The co-radially wound wires 640, 650 extend substantially along the entire length of the wire assembly, proximal to the resonant LC filter assembly. In other embodiments (not shown) the co-radial conductive wires may extend only along a portion of the lead body.

In the exemplary coiled configuration, first and second conductive wires are electrically insulated from one another. Both the first and second conductive wires 640, 650 may include an insulative or non-conductive coating. The insulative coating may be formed of a polyurethane material, nylon, polyester, polyester-amide, polyester-imide, polyester-amide-imide, silicone material, Teflon, expanded tetrafluoroethylene (eTFE), Polytetrafluoroethylene (pTFE), and the like. Alternatively, only one wire may be insulated. In any case, wires should be electrically isolated from each other.

As in previous embodiments, each co-radially wound wire 640, 650 is constructed from a single, continuous length of non-magnetic wire such as copper, titanium, titanium alloys, tungsten, gold, MP35N and combinations of the foregoing. If each wire is constructed from one length of wire, it may be a bondable wire such as heat, chemical or adhesively bondable to permit formation of the filters during manufacture with one wire. Alternatively, several lengths of non-continuous wire may be used and still fall within the intended scope of the invention. In such case the wires may be cast in silicone and heat-treated in certain location to ensure that the wire does not shift. Alternatively, glue or a wire having sufficient rigidity so that it holds its shape when bent may be used to prevent the wire comprising the circuit from shifting.

First and second resonant LC filter assemblies 626, 627, if included, are constructed as hereinbefore described. Resonant LC filters 626, 627 may be placed adjacent and proximal the IC at Coil to effectively block RF induced current from exiting the wire assembly thereby reducing the potential for destruction of the IC at Coil. Co-radially wound wires 640, 650 behave like non-resonant filters and attenuate the induced current on the wire itself thereby avoiding excessive heating.

As with other inductive cable constructs, wires 640, 650 are co-radially wound over a length of flexible tubing 340 made from polyimide, polyolefin, pTFE, eTFE, polyetherketone (PEK) and other similar flexible materials. The choice between utilizing co-radially wound wires versus discrete inductors on each wire depends on several factors. Co-radially wound wires can be implemented in a smaller diameter lead, since one wire never needs to pass over or under another, except at the resonant LC filters. However, the impedance of the discrete inductor approach may be more predictable and is not as dependent on length or bend of the device.

In the various embodiments presented herein the conductor includes a sufficient cross-sectional area such that the resistivity of the conductor at the MR operating frequency of 64 MHz for a 1.5 Tesla MRI is low enough to ensure that at Joule heating of the wire is minimal. In one embodiment, the wire may be a 36 AWG copper magnet wire for a circuit that is approximately one meter in length. Numerical modeling such as for example Finite Difference Time Domain (FDTD) or Method of Moments may be used to approximate the expected current for a particular device. The length of wire being used and the expected trajectory in the patient determines the desired total impedance across the circuit. Thus, for any particular length of wire the appropriate gauge may then be selected.

A current of 100 mA DC will result in approximately a 10 degree rise in temperature in a short section of Coiled 40 AWG wire. For a 36 AWG wire, the temperature rise is reduced to a 2 degree rise in temperature. For AC, the conductor resistance increases with frequency. An increase of five fold or greater is possible when comparing the DC resistance to the resistance of 60 MHZ, which directly translates to a greater temperature rise of the conductor for the same power input. The novel wire construct in accordance with the present invention is configured to be integrated into a 10 French or smaller wire assembly or catheter.

Although the present invention has been described with reference to the disclosed embodiments, various modifications and additions can be made to the exemplary embodiments discussed without departing from the scope of the present invention. For example, while the embodiments described above refer to particular features, the scope of this invention also includes embodiments having different combinations of features and embodiments that do not include all of the described features. Accordingly, the scope of the present invention is intended to embrace all such alternatives, modifications, and variations as fall within the scope of the claims.

## Claims

1. An MR active tracking system (10) comprising:
an integrated circuit active tracking coil, IC at coil, (11), comprising an active tracking coil (12), an integrated circuit proximate the active tracking coil (14), a frequency down-converter (24) configured to down-convert a magnetic resonance (MR) signal received by the active tracking coil, and a frequency generator (36);
a tracking receiver (20);
a first MR safe (16) means configured for transmitting a received and downconverted MR signal from the IC at coil (11) to the tracking receiver; and
a second MR safe means configured for communicating one or more signals from the tracking receiver to the IC at coil,
**characterised in that** said active tracking coil (12) is configured to sample an MR transmit excitation pulse, or alternatively **in that** the IC at coil comprises a separate sense coil configured to sample an MR transmit excitation pulse, and further **characterised in that** the frequency generator is configured to generate a reference frequency signal from the sampled MR transmit excitation pulse, and **in that** the frequency down-converter is configured for down-conversion of an MR signal received by the active tracking coil using the reference frequency signal.

2. The MR active tracking system of claim 1, wherein said tracking coil comprises traces on a circuit board, coiled wire or a dipole.

3. The MR active tracking system of claim 1, wherein the integrated circuit further comprises a low noise amplifier and the frequency down-converter.

4. The MR active tracking system of claim 1 wherein the first and/or second MR safe means comprises a wire assembly including a plurality of non-resonant filters, a plurality of high resistance wires, a fiber optic cable and combinations of the foregoing and wherein the wire assembly of the first and/or second MR safe means includes at least one resonant LC filter proximate the IC at Coil, proximate the tracking receiver or both.

5. The MR active tracking system of claim 1 wherein the IC at coil includes a fiber optic drive circuit and a modulator.

6. The MR active tracking system of claim 1 further comprising a frequency estimator circuit on the IC at coil configured to pass a frequency information signal from the integrated circuit to the tracking receiver through said first MR safe means, wherein said frequency information signal comprises a voltage, a light code, a pulse signal whose rate represents a frequency and combinations of the foregoing.

7. The MR active tracking system of claim 6 wherein said frequency information signal is implemented by a zero-crossing circuit configured to transmit a pulse of light to the tracking receiver through a fiber optic cable.

8. The MR active tracking system of claim 1 further comprising an analog to digital converter on the integrated circuit at coil, said analog to digital converter configured to communicate a digital signal from the integrated circuit to the tracking receiver through said first MR safe means.

9. The MR active tracking system of claim 1, wherein when the IC at coil comprises a separate sense coil, an output of the sense coil is amplified to generate the reference frequency signal.

10. The MR active tracking system of claim 1 wherein the tracking receiver is configured to supply power to the IC at coil through said second MR safe means.

11. The MR active tracking system of claim 1 wherein the tracking coil is configured to generate power on the IC at coil by harvesting power from the MR transmit excitation pulses.

12. The MR active tracking system of claim 1 further comprising a sense coil configured to generate power on the IC at coil by harvesting power from the MR transmit excitation pulses.

13. The MR active tracking system of claim 1 further including a wireless module operably coupled with the IC at coil by said first and second MR safe means and configured for wireless communication with the tracking receiver.

14. The MR active tracking system of claim 1 further comprising a plurality of tracking coils each of which is coupled to the integrated circuit with a single communication line.

## Patentansprüche

1. System zur aktiven MR-Verfolgung (10), umfassend:
eine aktive Verfolgungsspule einer integrierten Schaltung zur aktiven Verfolgung, Spulen-IS (IC at Coil), (11), umfassend eine aktive Verfolgungsspule (12), eine integrierte Schaltung nahe der aktiven Verfolgungsspule (14), einen Frequenzabwärtswandler (24), der zum Abwärtswandeln eines durch die aktive Verfolgungsspule empfangenen Magnetresonanz-(MR) -signals konfiguriert ist, und einen Frequenzgenerator (36) ;
einen Verfolgungsempfänger (20);
ein erstes MR-sicheres (16) Mittel, das zum Übertragen eines empfangenen und abwärtsgewandelten MR-Signals von der Spulen-IS (11) zum Verfolgungsempfänger konfiguriert ist, und
ein zweites MR-sicheres Mittel, das zum Übermitteln von ein oder mehr Signalen von dem Verfolgungsempfänger an die Spulen-IS (11) konfiguriert ist,
**dadurch gekennzeichnet, dass** die genannte aktive Verfolgungsspule (12) zum Abtasten eines MR-Übertragungsanregungsimpulses konfiguriert ist, oder alternativ, dass die IS at Coil eine separate Abtastspule umfasst, die zum Abtasten eines MR-Übertragungsanregungsimpulses konfiguriert ist, und ferner **dadurch gekennzeichnet, dass** der Frequenzgenerator zum Erzeugen eines Referenzfrequenzsignals aus dem abgetasteten MR-Übertragungsanregungsimpuls konfiguriert ist und dass der Frequenzabwärtswandler zur Abwärtswandlung eines durch die aktive Verfolgungsspule empfangenen MR-Signals unter Verwendung des Referenzfrequenzsignals konfiguriert ist.

2. System zur aktiven MR-Verfolgung nach Anspruch 1, wobei die genannte Verfolgungsspule Leiterbahnen auf einer Leiterplatte, gewickelten Draht oder einen Dipol umfasst.

3. System zur aktiven MR-Verfolgung nach Anspruch 1, wobei die integrierte Schaltung ferner einen rauscharmen Verstärker und den Frequenzabwärtswandler umfasst.

4. System zur aktiven MR-Verfolgung nach Anspruch 1, wobei das erste und/oder das zweite MR-sichere Mittel eine Drahtanordnung mit mehreren nichtresonanten Filtern, mehreren hochohmigen Drähten, einer Lichtwellenleiterleitung und Kombinationen der Vorhergehenden umfasst und wobei die Drahtanordnung des ersten und/oder zweiten MR-sicheren Mittels wenigstens ein resonantes LC-Filter nahe der Spulen-IS, nahe dem Verfolgungsempfänger oder beides aufweist.

5. System zur aktiven MR-Verfolgung nach Anspruch 1, wobei die Spulen-IS eine faseroptische Ansteuerschaltung und einen Modulator aufweist.

6. System zur aktiven MR-Verfolgung nach Anspruch 1, das ferner eine Frequenzschätzungsfunktionsschaltung auf der Spulen-IS, die zum Weiterleiten eines Frequenzinformationssignals von der integrierten Schaltung durch das genannte erste MR-sichere Mittel zum Verfolgungsempfänger konfiguriert ist, eine Spannung, einen Lichtcode, ein Pulssignal, dessen Rate eine Frequenz darstellt, und Kombinationen der vorgenannten umfasst.

7. System zur aktiven MR-Verfolgung nach Anspruch 6, wobei das Frequenzinformationssignal durch eine Nulldurchgangsschaltung implementiert ist, die zum Übertragen eines Lichtpulses über eine Lichtwellenleiterleitung an den Verfolgungsempfänger konfiguriert ist.

8. System zur aktiven MR-Verfolgung nach Anspruch 1, das ferner einen Analog-Digital-Wandler auf der integrierten Schaltung an der Spule umfasst, wobei der genannte Analog-Digital-Wandler zum Übermitteln eines digitalen Signals von der integrierten Schaltung durch das genannte erste MR-sichere Mittel zum Verfolgungsempfänger konfiguriert ist.

9. System zur aktiven MR-Verfolgung nach Anspruch 2, wobei, wenn die Spulen-IS eine separate Abtastspule umfasst, ein Ausgang der Abtastspule zum Erzeugen des Referenzfrequenzsignals verstärkt wird.

10. System zur aktiven MR-Verfolgung nach Anspruch 1, wobei der Verfolgungsempfänger zum Energieversorgung der Spulen-IS durch das genannte zweite MR-sichere Mittel konfiguriert ist.

11. System zur aktiven MR-Verfolgung nach Anspruch 1, wobei die Verfolgungsspule zur Erzeugung von Energie auf der Spulen-IS durch Entnahme von Energie aus den MR-Übertragungsanregungsimpulsen konfiguriert ist.

12. System zur aktiven MR-Verfolgung nach Anspruch 1, das ferner eine Abtastspule umfasst, die zur Erzeugung von Energie auf der Spulen-IS durch Entnahme von Energie aus den MR-Übertragungsanregungsimpulsen konfiguriert ist.

13. System zur aktiven MR-Verfolgung nach Anspruch 1, das ferner ein Drahtlos-Modul beinhaltet, das durch das genannte erste und zweite MR-sichere Mittel funktionell mit der Spulen-IS gekoppelt ist und zur drahtlosen Kommunikation mit dem Verfolgungsempfänger konfiguriert ist.

14. System zur aktiven MR-Verfolgung nach Anspruch 1, das ferner mehrere Verfolgungsspulen umfasst, die jeweils mit einer einzelnen Kommunikationsleitung mit der integrierten Schaltung gekoppelt sind.

## Revendications

1. Système de suivi actif de RM, (10) comprenant :
une bobine de suivi actif à circuit intégré, "IC au niveau de la bobine", (11), comprenant une bobine de suivi actif (12), un circuit intégré proche de la bobine de suivi actif (14), un convertisseur abaisseur de fréquence (24) configuré pour abaisser un signal de résonance magnétique (RM) reçu par la bobine de suivi actif, et un générateur de fréquence (36) ;
un récepteur de suivi (20) ;
un premier moyen non sensible à la RM (16) configuré pour transmettre un signal de RM reçu et abaissé de l'IC au niveau de la bobine (11) au récepteur de suivi ; et
un second moyen non sensible à la RM configuré pour communiquer un ou plusieurs signaux du récepteur de suivi à l'IC au niveau de la bobine,
**caractérisé en ce que** ladite bobine de suivi actif (12) est configurée pour échantillonner une impulsion d'excitation de transmission de RM, ou en variante **en ce que** l'IC au niveau de la bobine comprend une bobine de détection séparée configurée pour échantillonner une impulsion d'excitation de transmission de RM, et **caractérisé en outre en ce que** le générateur de fréquence est configuré pour générer un signal de fréquence de référence à partir de l'impulsion d'excitation de transmission de RM échantillonnée, et **en ce que** le convertisseur abaisseur de fréquence est configuré pour abaisser un signal de RM reçu par la bobine de suivi actif à l'aide du signal de fréquence de référence.

2. Système de suivi actif de résonance magnétique selon la revendication 1, dans lequel ladite bobine de suivi comprend des pistes sur une carte de circuit, un fil enroulé ou un dipôle.

3. Système de suivi actif de résonance magnétique selon la revendication 1, dans lequel le circuit intégré comprend en outre un amplificateur à faible bruit et le convertisseur abaisseur de fréquence.

4. Système de suivi actif de résonance magnétique selon la revendication 1 dans lequel le premier et/ou second moyen non sensible à la RM comprend un ensemble de fils comportant une pluralité de filtres non résonnants, une pluralité de fils de haute résistance, un câble de fibre optique et des combinaisons de ceux-ci et dans lequel l'ensemble de fils du premier et/ou second moyen non sensible à la RM comporte au moins un filtre LC résonnant proche de l'IC au niveau de la bobine, proche du récepteur de suivi ou des deux.

5. Système de suivi actif de résonance magnétique selon la revendication 1 dans lequel l'IC au niveau de la bobine comportent un circuit d'excitation à fibre optique et un modulateur.

6. Système de suivi actif de résonance magnétique selon la revendication 1 comprenant en outre un circuit estimateur de fréquence sur l'IC au niveau de la bobine configuré pour passer un signal d'information de fréquence du circuit intégré au récepteur de suivi par le biais dudit premier moyen non sensible à la RM, ledit signal d'information de fréquence comprenant une tension, un code de lumière, un signal pulsé dont la cadence représente une fréquence et des combinaisons de ceux-ci.

7. Système de suivi actif de résonance magnétique selon la revendication 6 dans lequel ledit signal d'information de fréquence est mis en œuvre par un circuit à franchissement du zéro configuré pour transmettre une impulsion de lumière vers le récepteur de suivi par le biais d'un câble de fibre optique.

8. Système de suivi actif de résonance magnétique selon la revendication 1 comprenant en outre un convertisseur analogique-numérique sur le circuit intégré au niveau de la bobine, ledit convertisseur analogique-numérique étant configuré pour communiquer un signal numérique du circuit intégré au récepteur de suivi par le biais dudit premier moyen non sensible à la RM

9. Système de suivi actif de résonance magnétique selon la revendication 9, dans lequel, quand l'IC à la bobine comprend une bobine de détection séparée, une sortie de la bobine de détection est amplifiée pour générer le signal de fréquence de référence.

10. Système de suivi actif de résonance magnétique selon la revendication 1 dans lequel le récepteur de suivi est configuré pour fournir une puissance à l'IC au niveau de la bobine par le biais dudit second moyen non sensible à la RM

11. Système de suivi actif de résonance magnétique selon la revendication 1 dans lequel la bobine de suivi est configurée pour générer une puissance sur l'IC au niveau de la bobine en récoltant la puissance des impulsions d'excitation de transmission de RM

12. Système de suivi actif de résonance magnétique selon la revendication 1 comprenant en outre une bobine de détection configurée pour générer une puissance sur l'IC au niveau de la bobine en récoltant la puissance des impulsions d'excitation de transmission de RM

13. Système de suivi actif de résonance magnétique selon la revendication 1 comportant en outre un module sans fil couplé fonctionnellement à l'IC au niveau de la bobine par lesdits premier et second moyens non sensibles à la RM et configuré pour communiquer en mode sans fil avec le récepteur de suivi.

14. Système de suivi actif de résonance magnétique selon la revendication 1 comprenant en outre une pluralité de bobines de suivi couplées chacune au circuit intégré par une seule ligne de communication.
